(19) **Europäisches Patentamt European Patent Office Office européen des brevets**

(11) **EP 4 737 733 A1**

(12) **EUROPEAN PATENT APPLICATION**
published in accordance with Art. 153(4) EPC

(43) Date of publication:
06.05.2026 Bulletin 2026/19

(21) Application number: 24831916.2

(22) Date of filing: 24.06.2024

(51) International Patent Classification (IPC):
*F04D 19/04* (2006.01)

(52) Cooperative Patent Classification (CPC):
**F04D 19/04; F04D 29/701**

(86) International application number:
**PCT/JP2024/022880**

(87) International publication number:
**WO 2025/005056 (02.01.2025 Gazette 2025/01)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: 27.06.2023 JP 2023104840

(71) Applicant: **Edwards Japan Limited Yachiyo-shi, Chiba 276-8523 (JP)**

(72) Inventor: **KABASAWA Takashi Yachiyo-shi Chiba 276-8523 (JP)**

(74) Representative: **Openshaw & Co. 8 Castle Street Farnham, Surrey GU9 7HR (GB)**

(54) **VACUUM EVACUATION DEVICE**

(57)     Provided is a vacuum exhaust device that can be plasma-cleaned favorably without providing a pressure regulation valve.

A vacuum exhaust device 10 having a turbo molecular pump 100 and a plasma generation device 210 includes a throttle portion 244 capable of increasing an internal pressure of the plasma generation device 210 so as to satisfy a relationship of

$$P \geq 0.3/D$$

where P is pressure [Pa] and D is a distance [m] between electrodes of the plasma generation device.

Further, the internal pressure of the plasma generation device 210 can be increased by the throttle portion to a pressure that satisfies a relationship of

$$P \leq 1.5/D.$$

Fig.5

## Description

[Technical Field]

The present invention relates to a vacuum exhaust device including a vacuum pump such as a turbo molecular pump, for example.

[Background Art]

A turbo molecular pump is generally known as a type of vacuum pump. For example, a turbo molecular pump is used as an exhaust in a device for manufacturing a semiconductor, a flat panel, or the like. In the turbo molecular pump, gas (process gas) that has been sucked into a pump main body is exhausted by applying a current to a motor in the pump main body in order to rotate rotor blades, whereby gas molecules of the gas are flicked away. This type of turbo molecular pump may also include a heater and a cooling pipe in order to manage an internal temperature of the pump appropriately.

In a vacuum pump such as a turbo molecular pump, a reaction product generated during the process for manufacturing a semiconductor or the like may accumulate inside the vacuum pump. PTL 1, cited below, discloses a technique for disposing a plasma generation device in a vacuum pump in order to plasma-clean the interior as a countermeasure against reaction products. PTL 1 also discloses a technique for disposing the plasma generation device on a side surface of the vacuum pump. In the invention described in PTL 1, a plasma source is disposed in a lead-in port disposed in the side surface of the vacuum pump. A valve disposed between the plasma source and the vacuum pump controls a supply of radicals.

[Citation List]

[Patent Literature]

[PTL 1] Japanese Patent Application Publication No. 2022-017864

[Summary of Invention]

[Technical Problem]

In a plasma generation device such as that disclosed in PTL 1, a raw material gas such as NF3 or CF4 flows between discharged electrodes, whereby the raw material gas is ionized. In this case, a discharge voltage between the electrodes takes a minimum value in the vicinity of a condition where a value of inter-electrode distance $\times$ pressure is 0.5 Pa·m (Paschen's law). Conventionally, therefore, although not shown in the figures, a valve (a pressure regulation valve, a valve device) is disposed near an outlet port of the vacuum pump, and pressure regulation is performed by controlling the valve so that the above condition is established between the electrodes of the plasma generation device.
As a result, the following problems occur.

(1) Disposing the pressure regulation valve near the outlet port requires installation space and involves cost.
(2) Since the pressure regulation valve is disposed on the downstream side of the vacuum pump, the entire interior of the vacuum pump has to be set at high pressure, leading to a reduction in a flow speed of radicals generated by the plasma generation device. As a result, a reaching distance of the radicals decreases (shortens). It is envisaged, for example, that approximately 90% of a degree of activity of the radicals is lost such that the degree of activity falls to approximately 10%. Further, during an operation of the vacuum pump, a pressure near the plasma generation device is reduced by the exhaust action of the vacuum pump, and therefore, with a method of disposing a valve downstream of the vacuum pump, it may be impossible to increase the pressure near the plasma generation device as desired. In order to increase the pressure near the plasma generation device to a desired pressure, a pressure near the outlet port of the vacuum pump has to be greatly increased, and as a result, in certain cases, the vacuum pump may overheat. Hence, with a conventional structure, it may be necessary to reduce a rotation speed of the vacuum pump or stop the vacuum pump in order to weaken an exhaust action of the pump.
(3) When a valve is not provided between the plasma generation device and the pump, unlike in the invention described in PTL 1, there is nothing to prevent reaction products from infiltrating the plasma generation device (accumulating in the plasma generation device).

An object of the present invention is to provide a vacuum exhaust device that can be plasma-cleaned favorably without providing a pressure regulation valve.

[Solution to Problem]

To achieve the object described above, a vacuum exhaust device according to the present invention is a vacuum exhaust device having a vacuum pump and a plasma generation device, the vacuum exhaust device including a throttle capable of increasing an internal pressure of the plasma generation device so as to satisfy a relationship of

$$P \geq 0.3/D$$

where P is pressure [Pa] and D is a distance [m] between electrodes of the plasma generation device.

[Advantageous Effects of Invention]

According to the invention described above, it is possible to provide a vacuum exhaust device that can be plasma-cleaned favorably without providing a pressure regulation valve.

[Brief Description of Drawings]

[Fig. 1]

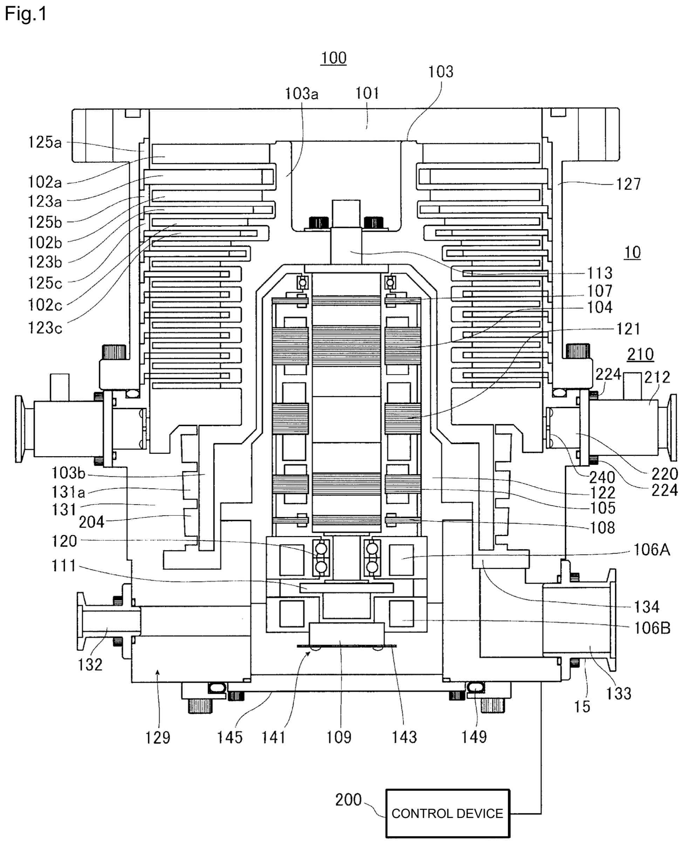

Fig. 1 is a schematic illustrative view showing a configuration of a vacuum exhaust device according to an embodiment of the present invention.
[Fig. 2]

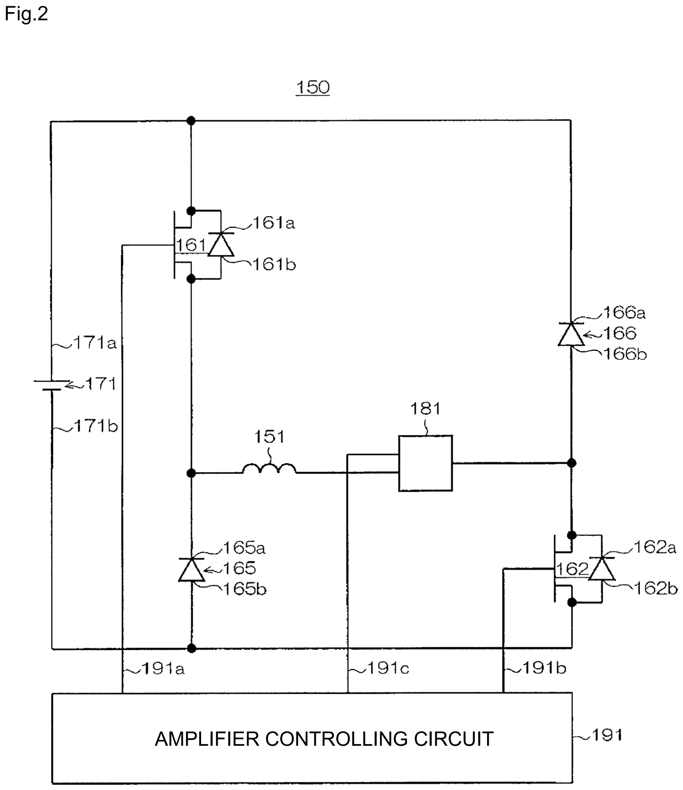

Fig. 2 is a circuit diagram of an amplifier circuit.
[Fig. 3]

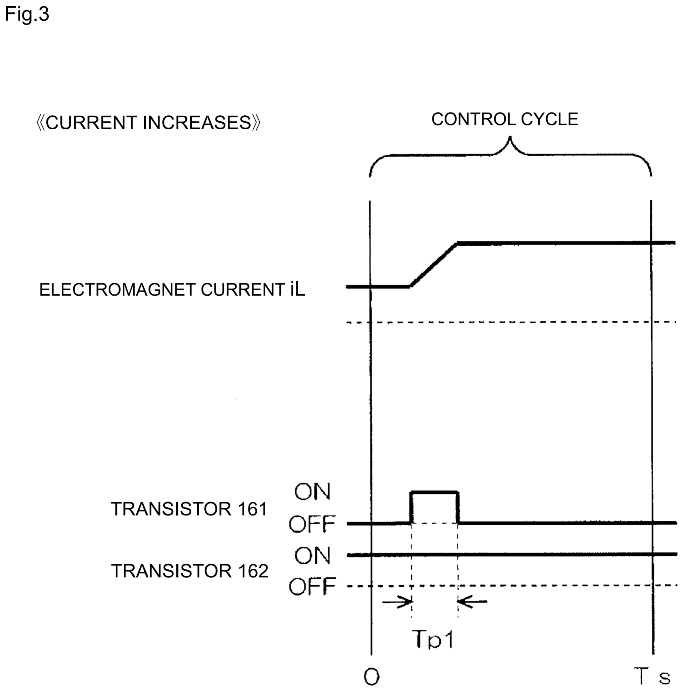

Fig. 3 is a time chart showing control performed when a current command value is larger than a detection value.
[Fig. 4]

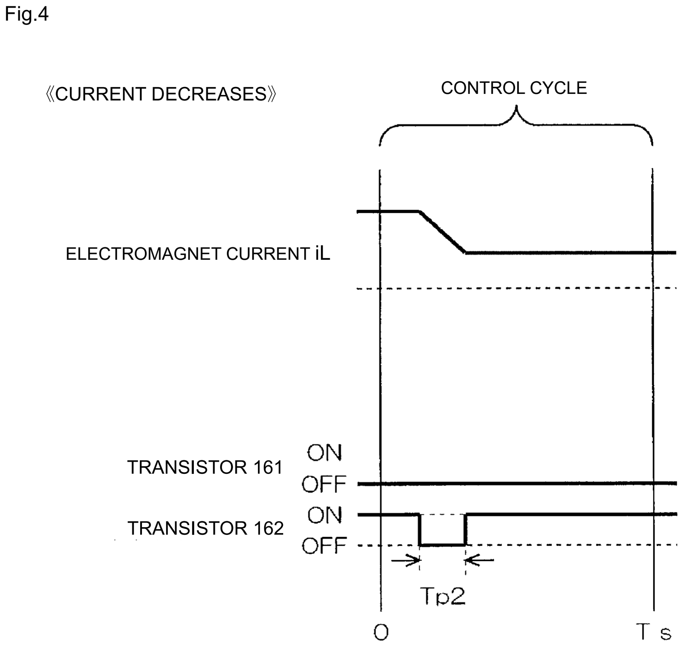

Fig. 4 is a time chart showing control performed when the current command value is smaller than the detection value.
[Fig. 5]

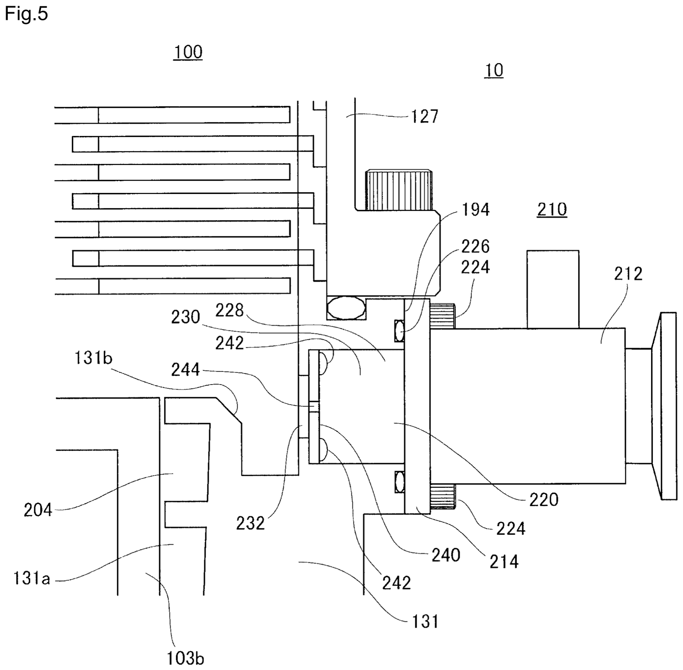

Fig. 5 is an illustrative view showing an enlargement of a connecting portion between a plasma generation device and a turbo molecular pump.
[Fig. 6]

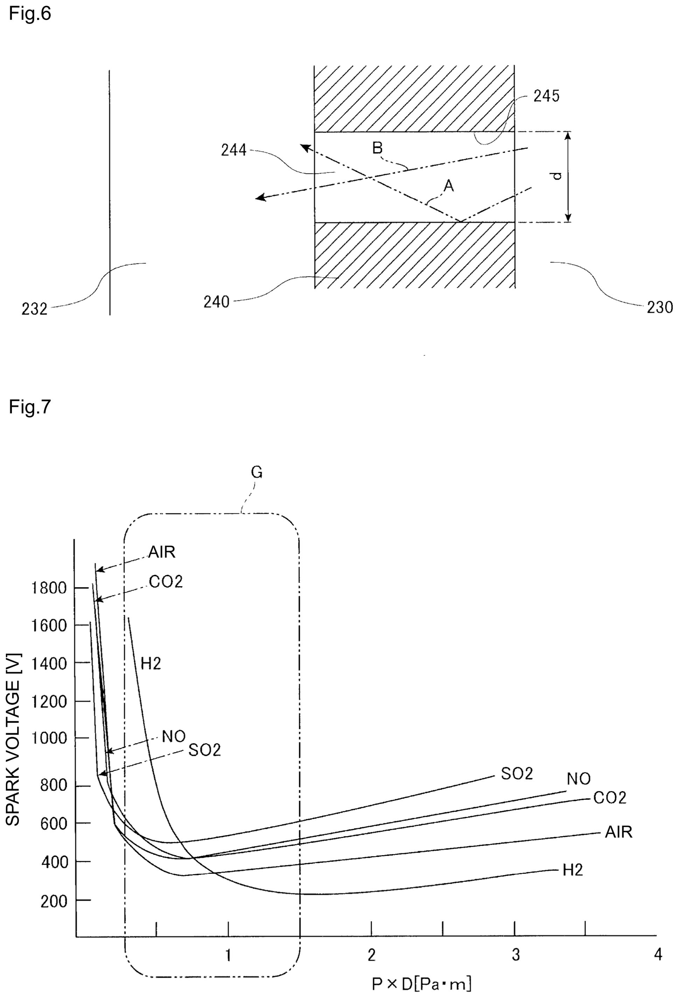

Fig. 6 is an illustrative view showing an enlargement of a throttle portion and the periphery thereof.
[Fig. 7]
Fig. 7 is a graph illustrating Paschen's law.
[Fig. 8]

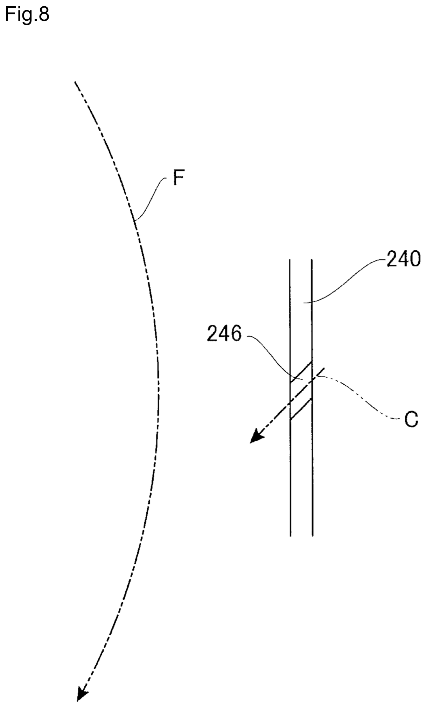

Fig. 8 is an illustrative view showing a modified example pertaining to the throttle portion.
[Fig. 9]

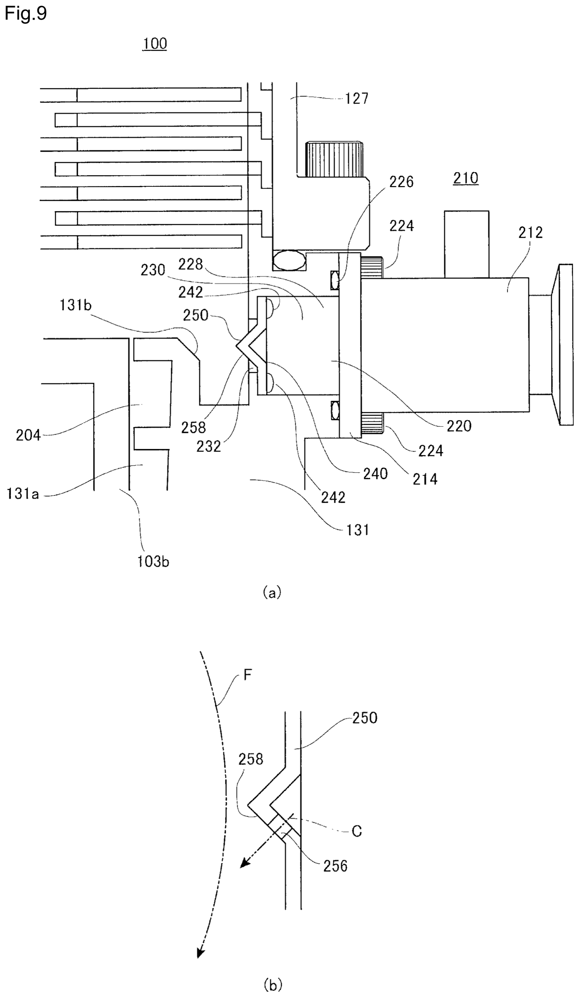

Fig. 9(a) is an illustrative view showing an enlargement of a connecting portion between the plasma generation device and the turbo molecular pump according to another modified example, and Fig. 9(b) is an illustrative plan view showing a throttle portion according to this modified example on a plan view.
[Fig. 10]

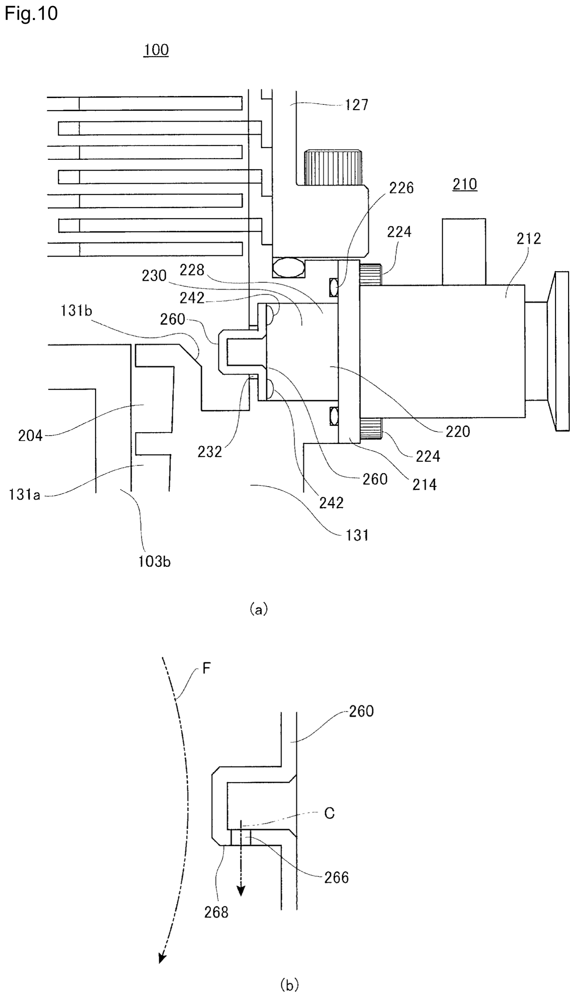

Fig. 10(a) is an illustrative view showing an enlargement of a connecting portion between the plasma generation device and the turbo molecular pump according to a further modified example, and Fig. 10(b) is an illustrative plan view showing a throttle portion according to this modified example on a plan view.

[Description of Embodiments]

<Basic configuration of vacuum exhaust device 10 according to an embodiment>
A vacuum exhaust device 10 according to an embodiment of the present invention will be described below on the basis of the figures. Fig. 1 shows the vacuum exhaust device 10 according to this embodiment of the present invention. The vacuum exhaust device 10 includes a turbo molecular pump 100 serving as a vacuum pump, and a plasma generation device 210. The turbo molecular pump 100 performs vacuum exhaust, and the plasma generation device 210 plasma-cleans reaction products formed in the turbo molecular pump 100.

<Turbo molecular pump 100>

Fig. 1 shows a longitudinal section of the turbo molecular pump 100. For example, the turbo molecular pump 100 is connected to a vacuum chamber (not shown) of a subject device such as a semiconductor manufacturing device or the like.

In the turbo molecular pump 100 of Fig. 1, an inlet port 101 is formed in an upper end of a cylindrical outer tube 127. A rotating body 103 in which a plurality of rotor blades 102 (102a, 102b, 102c, ...) are formed on a peripheral portion radially and in multiple stages, the rotor blades 102 serving as turbine blades for sucking and exhausting gas, is installed in the outer tube 127. A rotor shaft 113 is mounted in the center of the rotating body 103, and the rotor shaft 113 is supported and positionally controlled so as to levitate in the air by a 5-axis control magnetic bearing, for example.

Upper-side radial electromagnets 104 are arranged by disposing four electromagnets in pairs respectively on an X axis and a Y axis. Four upper-side radial sensors 107 are provided in proximity to the upper-side radial electromagnets 104 so as to correspond respectively to the upper-side radial electromagnets 104. The upper-side radial sensors 107 employ inductance sensors, eddy current sensors, or the like having a conductive winding, for example, and detect the position of the rotor shaft 113 on the basis of variation in the inductance of the conductive winding, which varies in accordance with the position of the rotor shaft 113. The upper-side radial sensors 107 are configured to detect radial displacement of the rotor shaft 113, or in other words the rotating body 103 fixed thereto, and transmit the detected displacement to a control device 200.

In the control device 200, a compensation circuit having a PID adjustment function, for example, generates excitation control command signals for the upper-side radial electromagnets 104 on the basis of position signals detected by the upper-side radial sensors 107, whereupon an amplifier circuit 150 shown in Fig. 2 (to be described below) controls excitation of the upper-side radial electromagnets 104 on the basis of the excitation control command signals, thereby adjusting the upper-side radial position of the rotor shaft 113.

The rotor shaft 113 is formed from a material (iron, stainless steel, or the like) with high magnetic permeability or the like so as to be attracted by the magnetic force of the upper-side radial electromagnets 104. The aforesaid adjustment is performed independently in each of an X axis direction and a Y axis direction. Furthermore, lower-side radial electromagnets 105 and lower-side radial sensors 108 are arranged similarly to the upper-side radial electromagnets 104 and the upper-side radial sensors 107 so that the lower-side radial position of the rotor shaft 113 is adjusted in a similar manner to the upper-side radial position.

Furthermore, axial electromagnets 106A, 106B are arranged above and below a disc-shaped metal disc (also referred to as an "armature disc") 111 provided in a lower portion of the rotor shaft 113. The metal disc 111 is formed from a material having high magnetic permeability, such as iron. An axial sensor 109 is provided to detect axial displacement of the rotor shaft 113, and an axial position signal therefrom is transmitted to the control device 200.

In the control device 200, the compensation circuit having a PID adjustment function, for example, generates an excitation control command signal for each of the axial electromagnet 106A and the axial electromagnet 106B on the basis of the axial position signal detected by the axial sensor 109, whereupon the amplifier circuit 150 controls excitation of each of the axial electromagnet 106A and the axial electromagnet 106B on the basis of the excitation control command signals. Accordingly, the axial electromagnet 106A attracts the metal disc 111 upward by magnetic force, the axial electromagnet 106B attracts the metal disc 111 downward by magnetic force, and as a result, the axial position of the rotor shaft 113 is adjusted.

Thus, the control device 200 is configured to appropriately adjust the magnetic force exerted on the metal disc 111 by the axial electromagnets 106A, 106B, whereby the rotor shaft 113 is magnetically levitated in an axial direction so as to be held in space without contact. Note that the amplifier circuit 150 that controls excitation of the upper-side radial electromagnets 104, the lower-side radial electromagnets 105, and the axial electromagnets 106A, 106B will be described below.

Meanwhile, a motor 121 includes a plurality of magnetic poles arranged peripherally so as to surround the rotor shaft 113. Each magnetic pole is controlled by the control device 200 so as to drive the rotor shaft 113 to rotate through electromagnetic force acting between the magnetic poles and the rotor shaft 113. Further, a rotation speed sensor such as a Hall element, a resolver, or an encoder, for example, not shown in the figures, is incorporated into the motor 121, and from a detection signal from the rotation speed sensor, the rotation speed of the rotor shaft 113 is detected.

Furthermore, for example, a phase sensor, not shown in the figures, is mounted near the lower-side radial sensors 108 in order to detect the phase of the rotation of the rotor shaft 113. In the control device 200, detection signals from the phase sensor and the rotation speed sensor are used together to detect the positions of the magnetic poles.

A plurality of stator blades 123 (123a, 123b, 123c, ...) are arranged at slight intervals (predetermined intervals) from the rotor blades 102 (102a, 102b, 102c, ...). The rotor blades 102 (102a, 102b, 102c, ...) are formed at an incline of a predetermined angle from a plane perpendicular to the axis of the rotor shaft 113 in order to respectively collide with molecules of exhaust gas and thereby convey the exhaust gas downward.

Further, the stator blades 123 are likewise formed at an incline of a predetermined angle from a plane perpendicular to the axis of the rotor shaft 113, and are arranged alternately with the stages of the rotor blades 102 so as to face the inside of the outer tube 127. Outer peripheral ends of the stator blades 123 are supported in a state of being inserted with play between a plurality of stacked stator blade spacers 125 (125a, 125b, 125c, ...).

The stator blade spacers 125 are ring-shaped members formed from a metal such as aluminum, iron, stainless steel, or copper, or a metal such as an alloy containing these metals as a component, for example. The outer tube 127 is fixed to the outer periphery of the stator blade spacers 125 with a slight gap left therebetween. The base portion 129 is disposed on a bottom portion of the outer tube 127. An outlet port 133 is formed to the base portion 129 and connected to the outside. Exhaust gas that enters the inlet port 101 from the side of a chamber (a vacuum chamber) so as to be conveyed toward the base portion 129 is sent to the outlet port 133.

Moreover, in accordance with the application of the turbo molecular pump 100, a screw spacer 131 is arranged between a lower portion of the stator blade spacers 125 and the base portion 129. The screw spacer 131 is a cylindrical member formed from a metal such as aluminum, copper, stainless steel, or iron, or an alloy containing these metals as a component, and has a plurality of spiral-shaped thread grooves 131a engraved in an inner peripheral surface thereof. The direction of the spirals of the thread grooves 131a is the direction in which molecules of the exhaust gas are conveyed toward the outlet port 133 when the molecules move in the rotation direction of the rotating body 103. A rotating body lower portion cylindrical portion 103b is suspended from a lower portion of a rotating body main body 103a of the rotating body 103, in which the rotor blades 102 (102a, 102b, 102c, ...) are formed. An outer peripheral surface of the rotating body lower portion cylindrical portion 103b is cylindrical and protrudes toward the inner peripheral surface of the screw spacer 131 so as to approach the inner peripheral surface of the screw spacer 131 with a predetermined gap left therebetween. The exhaust gas that is conveyed to the thread grooves 131a by the rotor blades 102 and stator blades 123 is sent to the base portion 129 while being guided by the thread grooves 131a. Thus, the screw spacer 131 and the opposing rotating body lower portion cylindrical portion 103b together form a Holweck exhaust mechanism unit 204. In the Holweck exhaust mechanism unit 204, the rotating body lower portion cylindrical portion 103b rotates relative to the screw spacer 131, thereby giving direction to the exhaust gas, and as a result, the exhaust characteristic of the turbo molecular pump 100 is improved.

The base portion 129 is a disc-shaped member forming a bottom portion of the turbo molecular pump 100, and is typically formed from a metal such as iron, aluminum, or stainless steel. The base portion 129 physically holds the turbo molecular pump 100 and also functions as a heat conduction path, and therefore a metal that is rigid and has high thermal conductivity, such as iron, aluminum, or copper, is preferably used.

In this configuration, when the rotor blades 102 are driven to rotate together with the rotor shaft 113 by the motor 121, exhaust gas is sucked from the chamber through the inlet port 101 by the actions of the rotor blades 102 and stator blades 123. The exhaust gas sucked through the inlet port 101 passes between the rotor blades 102 and the stator blades 123 so as to be conveyed to the base portion 129. At this time, the temperature of the rotor blades 102 increases due to friction heat generated when the exhaust gas comes into contact with the rotor blades 102, conduction of the heat generated by the motor 121, and so on, and this heat is transmitted to the stator blade 123 side by radiation or by being conducted by the gas molecules of the exhaust gas.

The stator blade spacers 125 are joined to each other by outer peripheral portions thereof so that the heat received by the stator blades 123 from the rotor blades 102, the friction heat generated when the exhaust gas comes into contact with the stator blades 123, and so on are transmitted to the outside.

Note that in the above description, the screw spacer 131 is disposed on the outer periphery of the rotating body lower portion cylindrical portion 103d of the rotating body 103, and the thread grooves 131a are engraved in the inner peripheral surface of the screw spacer 131. Conversely, however, the thread grooves may be engraved in the outer peripheral surface of the rotating body lower portion cylindrical portion 103b, and a spacer having a cylindrical inner peripheral surface may be disposed on the periphery thereof.

Furthermore, depending on the application of the turbo molecular pump 100, the periphery of electrical parts including the upper-side radial electromagnets 104, the upper-side radial sensors 107, the motor 121, the lower-side radial electromagnets 105, the lower-side radial sensors 108, the axial electromagnets 106A, 106B, the axial sensor 109, and so on may be covered by a stator column 122, and the interior of the stator column 122 may be maintained at a predetermined pressure using a purge gas (a protective gas), thereby ensuring that the gas sucked through the inlet port 101 does not infiltrate the electrical parts.

In this case, a port purge gas port (also referred to as a "purge gas introduction pipe") 132 is disposed in the base portion 129, and the purge gas is introduced through this pipe. The introduced purge gas is conveyed to the outlet port 133 between a protective bearing 120 and the rotor shaft 113, between a rotor and a stator of the motor 121, and through a gap 134 between inner peripheral-side cylindrical portions (a rotating body lower portion cylindrical portion 103b) of the rotor blades 102 and the stator column 122 and base portion 129.

Here, the turbo molecular pump 100 requires control based on model specification and individually regulated unique parameters (for example, characteristics corresponding to the model). In order to store these control parameters, the turbo molecular pump 100 includes, in a main body thereof, an electronic circuit portion 141. The electronic circuit portion 141 is constituted by a semiconductor memory such as an EEP-ROM, an electronic component such as a semiconductor element for accessing the semiconductor memory, a substrate 143 on which these components are mounted, and so on. The electronic circuit portion 141 is housed in a lower portion of a rotation speed sensor, not shown in the figures, near the center, for example, of the base portion 129 constituting the lower portion of the turbo molecular pump 100, and is closed by an airtight bottom lid 145.

Incidentally, in a semiconductor manufacturing process, a process gas introduced into a chamber may have a property whereby the process gas becomes a solid when the pressure thereof increases beyond a predetermined value or the temperature thereof decreases below a predetermined value. In the interior of the turbo molecular pump 100, the pressure of the exhaust gas is lowest in the inlet port 101 and highest in the outlet port 133. When the pressure of the process gas increases beyond a predetermined value or the temperature thereof decreases below a predetermined value as the process gas is conveyed from the inlet port 101 to the outlet port, the process gas takes a solid form, and the solid adheres to and is deposited in the interior of the turbo molecular pump 100.

For example, when SiCl4 is used as a process gas in an Al etching device, it can be seen from the vapor pressure curve that at low vacuum (760 [torr] to 10-2 [torr]) and low temperature (approximately 20 [°C]), a solid product (AlCl3, for example) is precipitated, and the solid product adheres to and is deposited in the interior of the turbo molecular pump 100. When, as a result, the precipitate of the process gas accumulates in the interior of the turbo molecular pump 100, the deposit narrows the pump flow passage, causing a reduction in the performance of the turbo molecular pump 100. Moreover, the aforesaid product is more likely to coagulate in and adhere to high-pressure parts near the outlet port 133 and the screw spacer 131.

Hence, to solve this problem, conventionally, a heater, not shown in the figures, or an annular (ring-shaped) water-cooling pipe 149 is wrapped around the outer periphery of the base portion 129 and so on, a temperature sensor (a thermistor, for example), not shown in the figures, is embedded in the base portion 129, for example, and control (referred to hereinafter as a TMS (Temperature Management System)) is performed to heat the heater or provide cooling through the water-cooling pipe 149 on the basis of a signal from the temperature sensor so as to maintain the temperature of the base portion 129 at a constant high temperature (a set temperature). In this embodiment, the screw spacer 131 is heated by a heater (not shown) embedded in the screw spacer 131, and the base portion 129 is cooled by a water-cooling pipe 149 embedded in the bottom lid 145.

Next, the amplifier circuit 150 for controlling excitation of the upper-side radial electromagnets 104, the lower-side radial electromagnets 105, and the axial electromagnets 106A, 106B will be described in relation to the turbo molecular pump 100 configured as described above. Fig. 2 is a circuit diagram of the amplifier circuit.

In Fig. 2, an electromagnet winding 151 constituting the upper-side radial electromagnets 104 and so on is connected at one end to a positive electrode 171a of a power supply 171 via a transistor 161 and connected at the other end to a negative electrode 171b of the power supply 171 via a current detection circuit 181 and a transistor 162. The transistors 161, 162 are so-called power MOSFETs, and are structured such that a diode is connected between the source and the drain thereof.

At this time, the transistor 161 is configured such that a cathode terminal 161a of the diode thereof is connected to the positive electrode 171a, and an anode terminal 161b is connected to one end of the electromagnet winding 151. Further, the transistor 162 is configured such that a cathode terminal 162a of the diode thereof is connected to the current detection circuit 181, and an anode terminal 162b is connected to the negative electrode 171b.

Meanwhile, a current regeneration diode 165 is configured such that a cathode terminal 165a thereof is connected to one end of the electromagnet winding 151, and an anode terminal 165b thereof is connected to the negative electrode 171b. Similarly, a current regeneration diode 166 is configured such that a cathode terminal 166a thereof is connected to the positive electrode 171a, and an anode terminal 166b thereof is connected to the other end of the electromagnet winding 151 via the current detection circuit 181. The current detection circuit 181 is constituted by, for example, a Hall sensor-type current sensor or an electrical resistor element.

The amplifier circuit 150 configured as described above corresponds to one electromagnet. Accordingly, in a case where the magnetic bearing performs 5-axis control and the electromagnets 104, 105, 106A, 106B total ten in number, a similar amplifier circuit 150 is formed for each electromagnet such that ten amplifier circuits 150 are connected in parallel to the power supply 171.

Furthermore, an amplifier control circuit 191 is constituted by, for example, a digital signal processor unit (referred to hereinafter as a DSP unit), not shown in the figures, of the control device 200, and the amplifier control circuit 191 switches the transistors 161, 162 ON and OFF.

The amplifier control circuit 191 compares a current value detected by the current detection circuit 181 (a signal reflecting this current value will be referred to as a current detection signal 191c) with a predetermined current command value. The magnitude (pulse width times Tp1, Tp2) of a pulse width generated in a control cycle Ts serving as one period of PWM control is then determined on the basis of the comparison result. As a result, gate drive signals 191a, 191b having this pulse width are output from the amplifier control circuit 191 to the gate terminals of the transistors 161, 162.

Note that when the rotation speed of the rotating body 103 passes through the resonance point during an acceleration operation, when a disturbance occurs during a constant speed operation, and so on, it is necessary to control the position of the rotating body 103 at high speed and with great force. Therefore, a high voltage of approximately 50 V, for example, is used as the power supply 171 so that the current flowing through the electromagnet winding 151 can be rapidly increased (or reduced). Further, a capacitor is normally connected between the positive electrode 171a and the negative electrode 171b of the power supply 171 in order to stabilize the power supply 171 (not shown).

In this configuration, when the transistors 161, 162 are both switched ON, the current (referred to hereinafter as an electromagnet current iL) flowing through the electromagnet winding 151 increases, and when the transistors 161, 162 are both switched OFF, the electromagnet current iL decreases.

Further, when one of the transistors 161, 162 is switched ON and the other is switched OFF, a so-called flywheel current is maintained. By passing a flywheel current through the amplifier circuit 150 in this manner, hysteresis loss in the amplifier circuit 150 can be reduced, making it possible to suppress the power consumption of the circuit as a whole. Moreover, by controlling the transistors 161, 162 in this manner, high frequency noise such as harmonics generated in the turbo molecular pump 100 can be reduced. Furthermore, by measuring the flywheel current using the current detection circuit 181, the electromagnet current iL flowing through the electromagnet winding 151 can be detected.

More specifically, as shown in Fig. 3, when the detected current value is smaller than the current command value, the transistors 161, 162 are both switched ON for a time corresponding to the pulse width time Tp1 once during the control cycle Ts (100 $\mu$s, for example). Accordingly, the electromagnet current iL during this period increases from the positive electrode 171a to the negative electrode 171b in the direction of a current value iLmax (not shown) that can flow through the transistors 161, 162.

As shown in Fig. 4, meanwhile, when the detected current value is larger than the current command value, the transistors 161, 162 are both switched OFF for a time corresponding to the pulse width time Tp2 once during the control cycle Ts. Accordingly, the electromagnet current iL during this period decreases from the negative electrode 171b to the positive electrode 171a in the direction of a current value iLmin (not shown) that can be regenerated through the diodes 165, 166.

In both cases, following the elapse of the pulse width times Tp1, Tp2, one of the transistors 161, 162 is switched ON. Accordingly, during this period, a flywheel current is maintained in the amplifier circuit 150.

In the turbo molecular pump 100 having this basic configuration, the upper side of Fig. 1 (the side of the inlet port 101) serves as an intake portion connected to the side of the subject device, and the lower side (the side of the base portion 129 on which the outlet port 133 is provided so as to project rightward in the figure) serves as an exhaust portion connected to an auxiliary pump (a back pump) or the like, not shown in the figure. As well as the vertically upright attitude shown in Fig. 1, the turbo molecular pump 100 can also be used in an inverted attitude, a horizontal attitude, or a tilted attitude.

Furthermore, in the turbo molecular pump 100, the outer tube 127 and the base portion 129, described above, are combined to form a single case (a combination of the two components will also be referred to hereinafter as a "main body casing" or the like). Moreover, the turbo molecular pump 100 is electrically (and structurally) connected to a box-shaped electrical case (not shown), and the control device 200 is incorporated into the electrical case.

The internal configuration of the main body casing (the combined outer tube 127 and base portion 129) of the turbo molecular pump 100 can be divided into a rotary mechanism unit for rotating the rotor shaft 113 and so on using the motor 121, and an exhaust mechanism unit that is driven to rotate by the rotary mechanism unit. Further, the exhaust mechanism unit can be considered to be divided into a turbo molecular pump mechanism unit constituted by the rotor blades 102, the stator blades 123, and so on, and a thread groove pump mechanism unit (the Holweck exhaust mechanism unit 204) constituted by the rotating body lower portion cylindrical portion 103b, the screw spacer 131, and so on.

Furthermore, the aforementioned purge gas (a protective gas) is used to protect the bearing part, the rotor blades 102, and so on by preventing corrosion caused by the exhaust gas (the process gas), cooling the rotor blades 102, and so on. The purge gas can be supplied by a typical method.

For example, the aforementioned purge gas port 132 is provided in a predetermined site (a position 90 degrees, 120 degrees, or the like away from the outlet port 133, or the like) of the base portion 129 so as to extend radially in a straight line. The purge gas is supplied to the purge gas port 132 from the outside of the base portion 129 through a purge gas cylinder (an N2 gas cylinder or the like), a flow rate controller (a valve device), or the like.

The protective bearing 120 described above is also known as a "touchdown (T/D) bearing", a "backup bearing", or the like. By employing the protective bearing 120, when, for example, a problem in the electrical system or a problem such as atmospheric inrush occurs, the position and attitude of the rotor shaft 113 do not vary greatly, and as a result, the rotor blades 102 and parts on the periphery thereof are not damaged.

Note that in Fig. 1, which shows the structures of the turbo molecular pump 100 and the rotating body 103, shading indicating cross-sections of the components has been omitted to avoid complicating the drawing.

<Plasma generation device 210 and throttle portion 244>

As noted above, products may accumulate in the interior of the turbo molecular pump 100. In this embodiment, the products are cleaned using the plasma generation device 210. Various types of devices may be used as the plasma generation device 210. For example, a device that generates plasma (which in this case may also be said to be "radicals") oriented toward the turbo molecular pump 100 by applying a high-frequency voltage to an electrode provided in the interior of a cylinder 212 can be used as the plasma generation device 210.

The plasma generation device 210 is connected to a side surface of the turbo molecular pump 100. In this embodiment, the plasma generation device 210 is provided in a plurality. In Fig. 1, two plasma generation devices 210 are disposed on the turbo molecular pump 100 at an interval of 180 degrees. Instead, for example, the number of plasma generation devices 210 may be set at four, and the four plasma generation devices 210 may be disposed at 90-degree intervals.

A boundary part between the plasma generation device 210 and the turbo molecular pump 100 serves as a connecting portion 220. The interior of the plasma generation device 210 and the interior of the turbo molecular pump 100 are spatially connected through the connecting portion 220.

Fig. 5 schematically shows an enlargement of the interior of the connecting portion 220. At connecting portion 220, a flange portion 214 of the plasma generation device 210 is fixed to a seat surface 194 on the base portion 129 of the turbo molecular pump 100 by a hexagonal socket bolt 224. An airtight seal is formed between the flange portion 214 of the plasma generation device 210 and the seat surface 194 of the turbo molecular pump 100 by a sealing member (here, an O-ring) 226.

A plasma connecting port 228 is formed in the base portion 129 of the turbo molecular pump 100. The plasma connecting port 228 connects the internal space of the turbo molecular pump 100 to the internal space of the plasma generation device 210. The plasma connecting port 228 is formed in the shape of a hole having a step, and includes a lead-in portion 230 with a relatively larger inner diameter, and a lead-out portion 232 with a relatively small inner diameter. The lead-in portion 230 is positioned on the side of the plasma generation device 210, and the lead-out portion 232 is positioned on the side of the internal space of the turbo molecular pump 100.

A disc-shaped throttle member 240 is fixed (screwed) by a small screw 242 to a bottom portion of the lead-in portion 230. A throttle portion 244 is formed in the throttle member 240. The throttle portion 244 is a circular hole (a round hole) that penetrates the throttle member 240 in a thickness direction. Here, the plasma generation device 210 can be mounted on the base portion 129 after mounting the throttle member 240 on the base portion 129.

The thickness direction of the throttle portion 244 coincides with the radial direction (a direction orthogonal to the rotary axis) of the turbo molecular pump 100. Further, the throttle portion 244 is formed such that a diameter d thereof (Fig. 6) remains constant in the thickness direction of the throttle member 240. The throttle portion 244 functions as an orifice that connects the lead-in portion 230 to the lead-out portion 232.

Plasma generated by the plasma generation device 210 passes through the throttle portion 244 from the lead-in portion 230 and arrives at the lead-out portion 232. The plasma that passes through the throttle portion 244 includes plasma that reaches the lead-out portion 232 by colliding with an inner wall 245 of the throttle portion 244, as shown by an arrow A in Fig. 6, plasma that reaches the lead-out portion 232 without colliding with the inner wall 245 of the throttle portion 244, as shown by an arrow B in Fig. 6, and so on. Fig. 6 shows shading representing a cross-section of the throttle member 240.

Surface treatment is implemented on the throttle member 240 including the throttle portion 244. Ceramic coating, alumite treatment, and so on, for example, can be employed as the surface treatment. By implementing the surface treatment, electrical insulation can be applied to the throttle member 240. The surface treatment may be performed only on the throttle portion 244.

In the example of Fig. 5 (and Fig. 6), most of the plasma that reaches the lead-out portion 232 collides with the screw spacer 131. The throttle portion 244 is disposed in substantially the same position as an inclined surface 131b of the screw spacer 131 in the axial direction of the turbo molecular pump 100. Therefore, most of the plasma traveling toward the screw spacer 131 collides with the inclined surface 131b of the screw spacer 131.

The throttle portion 244 is capable of increasing (raising) the pressure (the pressure around the electrodes) in the internal space of the plasma generation device 210. The throttle portion 244 is formed so that the pressure that is reached as the pressure is increased satisfies the following relationship on the basis of Paschen's law.

$$0.3/D \leq P \leq 1.5/D$$

Here, P is the pressure [Pa] and D is the distance [m] between the electrodes of the plasma generation device.

Paschen's law is a law pertaining to the relationship between the voltage at which spark discharge occurs, the gas pressure in the environment, and the inter-electrode distance. Spark discharge occurs when a strong electric field is applied to a gas, eventually leading to dielectric breakdown. Between parallel electrodes, the voltage (spark voltage) [V] at which spark discharge occurs can be expressed as a function of a product of the gas pressure [P] and the inter-electrode distance [D].

Fig. 7 shows a Paschen curve. The vertical axis on the graph of Fig. 7 shows the spark voltage [V], and the horizontal axis shows the product [P×D] of the gas pressure [P] and the inter-electrode distance [D]. Spark discharge occurs when electrons collide with gas molecules such that the gas is ionized. Accordingly, as shown in Fig. 7, there is a value of [P×D] at which the spark voltage [V] reaches a minimum. When the pressure is too low, (when [P] is too small), collisions are less likely to occur between the electrons and the gas molecules, and conversely, when the pressure is too high, it is difficult to accelerate the electrons enough to collide. Furthermore, as shown in Fig. 7, the spark voltage increases when [P×D] is both too large and too small. Therefore, to generate spark discharge at a low voltage, it is effective to set [P×D] in an appropriate range.

In this embodiment, as shown by a dot-dot-dash line frame G on the graph in Fig. 7, the relationship between the pressure [P] and the inter-electrode distance [D] is determined such that the value of [P×D] on the horizontal axis is 0.3 to 1.5 [Pa·m]. Thus, the spark voltage can be kept low with respect to various types of gases.

To cite a specific example, when, for example, the inter-electrode distance [D] is 5 mm (= 5 × 10 - 3 [m]), the appropriate range of [P] is 60 to 300 [Pa]. Further, although not shown in Fig. 7, when the raw material gas is NF3, the raw material gas is supplied at 50 [sccm] (Standard Cubic Centimeters per Minute), and an orifice (here, the throttle portion 244) with an aperture of approximately 2 to 5 [mm] is disposed, the pressure in the plasma generation device (here, the plasma generation device 210) remains within an appropriate range, whereby discharge can be performed with stability even at a low voltage.

Here, relationships between the flow rate in the orifice, the sectional area of the orifice, and the differential pressure can be determined using various calculation formulae. For example, these relationships can be determined using the following formula.

$$Q = CA0 \ (2\Delta P/\rho) \ - \ 1/2 \qquad\qquad (1)$$

Here, the symbols used above in formula (1) mean the following.

Q: flow rate (m3/s)
C: flow rate coefficient
A0 = $\pi$D2/4: sectional area [m2] of orifice hole, D being the diameter [m] of the orifice hole
$\rho$: fluid density [kg/m3]
$\Delta$P: differential pressure [Pa] between front and rear of orifice

In the vacuum exhaust device 10 according to this embodiment, as described above, the throttle portion 244 is used as an orifice for generating discharge at a low voltage, and therefore the pressure in the internal space of the plasma generation device 210 can be adjusted simply by disposing the throttle member 240. Moreover, in contrast to the prior art, there is no need to open and close the flow passage using a pressure regulation valve on the downstream side of the turbo molecular pump 100. Accordingly, neither a pressure regulation valve nor a control circuit for the pressure regulation valve is required. As a result, space for disposing the pressure regulation valve is not required, and the cost of the pressure regulation valve is not required. Furthermore, since space for disposing the pressure regulation valve is not required, the freedom of arrangement with respect to the vacuum exhaust device 10 and the turbo molecular pump 100 increases. Moreover, since there is no need to dispose a pressure regulation valve downstream of the vacuum pump (here, the turbo molecular pump 100), the pressure near the plasma generation device can easily be increased as desired. In addition, there is no need to weaken the exhaust action of the vacuum pump by reducing the rotation speed of the vacuum pump or stopping the pump.

Moreover, the throttle member 240 is a plate-shaped member, and therefore the size of the pressure regulation mechanism can be reduced more easily than with the valve (a radical supply valve 201b) described in PTL 1, for example. This also means that the space required to dispose the vacuum exhaust device 10 can be reduced.

Furthermore, since the throttle member 240 is a plate-shaped body, the thickness thereof can be reduced. Accordingly, the length of the gas flow passage and the length and area of the inner wall 245 of the gas flow passage can be reduced. As a result, radicals that collide with the wall surface of the inner wall 245 so as to be deactivated can be minimized.

Moreover, the downstream side of the throttle portion 244 can be kept at a relatively low pressure, whereby the flow speed of the radicals can be increased. Accordingly, the radicals are more likely to reach the downstream side before being deactivated. As a result, a superior plasma cleaning effect is obtained.

Furthermore, the throttle portion 244 is formed simply by disposing the throttle member 240 in the connecting portion 220 between the plasma generation device 210 and the turbo molecular pump 100. The throttle member 240 is disposed on the connecting portion 220 by being screwed thereto. Hence, the throttle member 240 can be mounted easily, and as a result, the throttle portion 244 can be formed easily.

In addition, surface treatment such as ceramic coating or alumite treatment is implemented on the throttle member 240, and therefore the throttle portion 244 can be made highly resistant to the radicals. Furthermore, when the radicals collide with the wall surface of the inner wall 245, the probability that the radicals will recombine can be suppressed.

Moreover, the throttle portion 244 is an open hole, and the turbo molecular pump 100 and plasma generation device 210 are spatially connected through the throttle portion 244. Therefore, the purge gas of the turbo molecular pump 100 can easily be led into the plasma generation device 210. Hence, simply by supplying a small amount of purge gas to the plasma generation device 210, reaction products can be prevented from infiltrating (accumulating in) the plasma generation device 210.

Note that in the embodiment described above, the throttle portion 244 extends in the thickness direction of the throttle member 240. However, the present invention is not limited thereto, and as shown in Fig. 8, for example, the throttle portion 244 may be formed at an incline relative to the thickness direction of the throttle member 240. Fig. 8 schematically shows the state of a throttle portion 246 on a plan view seen from the intake side (the upstream side of the exhaust gas) of the turbo molecular pump 100. Similarly to Fig. 5 and so on, shading has been omitted. An arrow C indicates a lead-out direction (a representative lead-out direction) of the plasma, and an arrow F indicates the rotation direction of the turbo molecular pump 100. The direction indicated by the arrow F substantially coincides with the flow direction of the exhaust gas, which flows in a spiral shape.

In the example of Fig. 8, the throttle portion 246 is a hole that inclines in a direction intersecting the radial direction of the turbo molecular pump 100. Further, the throttle portion 246 is oriented in the rotation direction of the turbo molecular pump 100 (the direction of the arrow C) and extends along the rotation direction (the direction of the arrow C).

Here, "inclines in a direction intersecting the radial direction of the turbo molecular pump 100" may also mean, for example, "is oriented horizontally and at an incline relative to the radial direction of the turbo molecular pump 100" or the like. Further, "oriented in the rotation direction" and "along the rotation direction" may also mean "facing the rotation direction at an incline to both a tangential direction and a normal direction relative to the rotation direction" or the like. Furthermore, the exhaust gas flows in a spiral shape from the intake side to the exhaust side, and therefore the throttle portion 246 may be oriented at an incline relative to the direction of the rotary axis (inclined from the intake side toward the exhaust side).

The direction in which the throttle portion 246 extends in this case is a direction that allows the plasma led out from the throttle portion 246 to converge smoothly with the gas flowing through the turbo molecular pump 100. The opening of the throttle portion 246 that faces the turbo molecular pump 100 side is also oriented at an incline relative to the inclined surface 131b of the screw spacer 131.

By setting the orientation of the throttle portion 246 as shown in the example of Fig. 8, plasma can be efficiently guided into the turbo molecular pump 100. As a result, the plasma flows smoothly through the turbo molecular pump 100 to the downstream side of the gas flow passage. Accordingly, a superior plasma cleaning effect is obtained. Moreover, the throttle portion 246 opens at an incline relative to the radial direction of the screw spacer 131 (Fig. 5), and it is therefore possible to prevent the plasma from colliding with the screw spacer 131 (here, the inclined surface 131b), with the result that the plasma is deactivated, to the maximum extent.

Furthermore, as shown in Figs. 9(a), 9(b), 10(a), and 10(b), throttle members 250 and 260 can be formed in three-dimensional shapes rather than the flat plate shape described heretofore. In the example of Figs. 9(a) and 9(b), the throttle member 250 is formed in a shape having a triangular cross-section, for example. Examples of shapes having a triangular cross-section include a conical shape, a triangular pyramid shape, a quadrangular pyramid shape, and so on.

Fig. 9(b), similarly to Fig. 8, schematically shows the state of a throttle portion 256 on a plan view seen from the intake side (the upstream side of the exhaust gas) of the turbo molecular pump 100. An arrow C indicates the lead-out direction (a representative lead-out direction) of the plasma, and an arrow F, similarly to Fig. 8, indicates the rotation direction of the turbo molecular pump 100.

The throttle portion 256 extends so as to penetrate an inclined surface 258 of the throttle member 250 in a thickness direction, and opens onto the inclined surface 131b of the screw spacer 131 in an oblique direction. Thus, the plasma can be efficiently guided into the turbo molecular pump 100 and allowed to flow smoothly through the turbo molecular pump 100 to the downstream side of the gas flow passage. As a result, a superior plasma cleaning effect is obtained. Moreover, it is therefore possible to prevent the plasma from colliding with the screw spacer 131 (here, the inclined surface 131b), with the result that the plasma is deactivated, to the maximum extent.

Note that since the exhaust gas flows in a spiral shape from the intake side toward the exhaust side, the throttle portion 256 may also be oriented at an incline relative to the direction of the rotary axis (inclined from the intake side toward the exhaust side).

In the example of Figs. 10(a) and 10(b), the throttle member 260 is formed in a shape having a rectangular cross-section. Examples of shapes having a rectangular cross-section include a cylindrical shape, a cube shape, a rectangular parallelepiped shape, and so on. Further, although not shown in the figure, a tapered (or thick-tipped) trapezoidal shape may also be used.

Fig. 10(b), similarly to Figs. 8 and 9(b), schematically shows the state of a throttle portion 266 on a plan view seen from the intake side (the upstream side of the exhaust gas) of the turbo molecular pump 100. An arrow C indicates the lead-out direction (a representative lead-out direction) of the plasma, and an arrow F, similarly to Figs. 8 and 9(b), indicates the rotation direction of the turbo molecular pump 100.

The throttle portion 266 extends so as to penetrate a side surface 268 of the throttle member 260 in a thickness direction, and opens onto the inclined surface 131b of the screw spacer 131 in a perfectly horizontal direction. Thus, the plasma can be efficiently guided into the turbo molecular pump 100 and allowed to flow smoothly through the turbo molecular pump 100 to the downstream side of the gas flow passage. As a result, a superior plasma cleaning effect is obtained. Moreover, it is therefore possible to prevent the plasma from colliding with the screw spacer 131 (here, the inclined surface 131b, with the result that the plasma is deactivated, to the maximum extent.

Note that since the exhaust gas flows in a spiral shape from the intake side toward the exhaust side, the throttle portion 266 may also be oriented at an incline relative to the direction of the rotary axis (inclined from the intake side toward the exhaust side).

Moreover, although not shown in the figures, various types of electrodes, such as disc-shaped, double cylinder-shaped, parallel plate-shaped, and so on, for example, can be employed as the electrodes in the interior of the plasma generation device 210.

Further, the location in which to dispose the throttle member (for example, the throttle members 240, 250, 260) is not limited to a location outside the plasma generation device 210 (a location inside the turbo molecular pump 100, for example), and the throttle member may be disposed in a location inside the plasma generation device 210, a location at the plasma outlet, and so on.

Furthermore, a variable orifice including a mechanism for varying the aperture can be employed as the throttle portion (for example, the throttle portions 244, 246, 256, 266). Note, however, that in the vacuum exhaust device 10 described above, the flow rate can be modified by modifying the pressure, and it is therefore unnecessary to complicate the structure by using a variable orifice.

Moreover, the throttle portion is not limited to an orifice, and as long as similar effects can be obtained, a hole-shaped site formed in a valve device or a hole-shaped site formed in a needle-shaped member, for example, may be used instead.

<Inventions that can be extracted from the embodiments>

The following inventions can be extracted from the embodiments described above.

(1) A vacuum exhaust device (the vacuum exhaust device 10 or the like) having a vacuum pump (the turbo molecular pump 100 or the like) and a plasma generation device (the plasma generation device 210 or the like), the vacuum exhaust device including a throttle (the throttle portion 244, 246, 256, 266, a hole-shaped site in a valve device, a hole-shaped site formed in a needle-shaped member, or the like) capable of increasing an internal pressure of the plasma generation device so as to satisfy a relationship of

$$P \geq 0.3/D$$

where P is pressure [Pa] and D is a distance [m] between electrodes of the plasma generation device.
(2) The vacuum exhaust device described above in (1), wherein the internal pressure of the plasma generation device can be increased by the throttle to a pressure that satisfies a relationship of

$$P \leq 1.5/D.$$

(3) The vacuum exhaust device described above in (1) or (2), wherein the throttle is disposed in a connecting portion (the connecting portion 220 or the like) between the vacuum pump and the plasma generation device.
(4) The vacuum exhaust device described above in (1) or (2), wherein the throttle is an orifice.
(5) The vacuum exhaust device described above in (1) or (2), wherein the throttle includes a hole that is inclined in a direction intersecting a radial direction of the vacuum pump.
(6) The vacuum exhaust device described above in (1) or (2), wherein the throttle is coated with ceramic.
(7) The vacuum exhaust device described above in (1) or (2), wherein the throttle is treated with alumite.

<Miscellaneous>

Note that the present invention is not limited to the embodiments described above, and the embodiments may be amended or combined in various ways within a scope that does not depart from the spirit of the invention.

[Reference Signs List]

| 10 | Vacuum exhaust device |
|---|---|
| 100 | Turbo molecular pump |
| 210 | Plasma generation device |
| 220 | Connecting portion |
| 228 | Plasma connecting port |
| 230 | Lead-in portion |
| 232 | Lead-out portion |
| 240, 250, 260 | Throttle member |
| 244, 246, 256, 266 | Throttle portion |
| 245 | Inner wall |

**Claims**

1. A vacuum exhaust device having a vacuum pump and a plasma generation device, the vacuum exhaust device comprising a throttle capable of increasing an internal pressure of the plasma generation device so as to satisfy a relationship of

$$P \geq 0.3/D$$

where P is pressure [Pa] and D is a distance [m] between electrodes of the plasma generation device.

2. The vacuum exhaust device according to claim 1, wherein the internal pressure of the plasma generation device can be increased by the throttle to a pressure that satisfies a relationship of

$$P \leq 1.5/D.$$

3. The vacuum exhaust device according to claim 1 or 2, wherein the throttle is disposed in a connecting portion between the vacuum pump and the plasma generation device.

4. The vacuum exhaust device according to claim 1 or 2, wherein the throttle is an orifice.

5. The vacuum exhaust device according to claim 1 or 2, wherein the throttle includes a hole that is inclined in a direction intersecting a radial direction of the vacuum pump.

6. The vacuum exhaust device according to claim 1 or 2, wherein the throttle is coated with ceramic.

7. The vacuum exhaust device according to claim 1 or 2, wherein the throttle is treated with alumite.

Fig.1

CONTROL DEVICE

Fig.2

150

AMPLIFIER CONTROLLING CIRCUIT

Fig.3

《CURRENT INCREASES》

CONTROL CYCLE

ELECTROMAGNET CURRENT iL

TRANSISTOR 161    ON / OFF

TRANSISTOR 162    ON / OFF

Tp1

O                              T s

Fig.4

《CURRENT DECREASES》

CONTROL CYCLE

ELECTROMAGNET CURRENT iL

TRANSISTOR 161    ON
                 OFF

TRANSISTOR 162    ON
                  OFF

Tp2

O                                    T s

Fig.5

100

10

127

194

210

226
224

212

230 228

242

131b

244

204

232

131a

103b

220

224

240 214

242

131

Fig.6

Fig.7

Fig.8

Fig.9

100

127

226

210

224

212

230 228
242

131b

250

204

131a

258
232

103b

240 214

242

131

220

(a)

F

250

258

C

256

(b)

Fig.10

100

(a)

(b)

## INTERNATIONAL SEARCH REPORT

| | International application No. |
|---|---|
| | **PCT/JP2024/022880** |

**A. CLASSIFICATION OF SUBJECT MATTER**

*F04D 19/04*(2006.01)i

FI: F04D19/04 G

According to International Patent Classification (IPC) or to both national classification and IPC

**B. FIELDS SEARCHED**

Minimum documentation searched (classification system followed by classification symbols)

F04D19/04

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2022-017864 A (EDWARDS KK) 26 January 2022 (2022-01-26)<br>paragraph [0065], fig. 1 | 1-7 |
| Y | JP 2014-109232 A (SHIMADZU CORPORATION) 12 June 2014 (2014-06-12)<br>paragraphs [0019]-[0020], fig. 2-3 | 1-7 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **19 September 2024** | **01 October 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

International application No.

**PCT/JP2024/022880**

| Patent document cited in search report | | | Publication date (day/month/year) | Patent family member(s) | | | Publication date (day/month/year) |
|---|---|---|---|---|---|---|---|
| JP | 2022-017864 | A | 26 January 2022 | US | 2023/0220848 | A1 | |
| | | | | paragraph [0077], fig. 1 | | | |
| | | | | WO | 2022/014442 | A1 | |
| | | | | EP | 4184013 | A1 | |
| | | | | CN | 115667725 | A | |
| | | | | KR | 10-2023-0034946 | A | |
| | | | | IL | 299043 | A | |
| JP | 2014-109232 | A | 12 June 2014 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022017864 A